**Europäisches Patentamt**

**European Patent Office**

**Office européen des brevets**

(19)

(11) **EP 1 420 516 A2**

(12) **EUROPÄISCHE PATENTANMELDUNG**

(43) Veröffentlichungstag:
**19.05.2004 Patentblatt 2004/21**

(51) Int Cl.⁷: **H03M 1/06**

(21) Anmeldenummer: **03020864.9**

(22) Anmeldetag: **15.09.2003**

(84) Benannte Vertragsstaaten:
**AT BE BG CH CY CZ DE DK EE ES FI FR GB GR
HU IE IT LI LU MC NL PT RO SE SI SK TR**
Benannte Erstreckungsstaaten:
**AL LT LV MK**

(30) Priorität: **13.11.2002 DE 10252756**

(71) Anmelder: **ROBERT BOSCH GMBH
70442 Stuttgart (DE)**

(72) Erfinder:
• **Geiger, Albert
71735 Eberdingen (DE)**
• **Rieger, Reinhard
74336 Brackenheim (DE)**
• **Fahrenbach, Michael
72766 Mittelstadt (DE)**
• **Landsgesell, Jürgen
74076 Heilbronn (DE)**

(54) **A/D-Wandler mit verbesserter Auflösung**

(57) Die Erfindung betrifft ein Verfahren zur Verbesserung der Auflösung eines A/D-Wandlers (6) bzw. eine Wandleranordnung mit einem S/H-Glied (4) und einem A/D-Wandler (6). Um die Auflösung des A/D-Wandlers (6) zu verbessern wird vorgeschlagen, ein Analogsignal (1) mit einem Hilfssignal (2) zu überlagern, das überlagerte Signal (3) abzutasten und mittels des A/D-Wandlers (6) in digitale Ausgangswerte (7) zu wandeln. Aus den digitalen Ausgangswerten (7) läßt sich z.B. durch Mittelwertbildung ein Ausgangswert (10) mit höherer Auflösung ermitteln.

Fig. 1

EP 1 420 516 A2

**Beschreibung**

Die Erfindung betrifft ein Verfahren zur Verbesserung der Auflösung eines A/D-Wandlers gemäß dem Oberbegriff des Patentanspruchs 1 sowie eine A/D-Wandleranordnung mit einem S/H-Glied (S/H: Sample/Hold; Abtast- und Halteglied) und einem A/D-Wandler gemäß dem Oberbegriff des Patentanspruchs 8.

A/D-Wandler (Analog/Digital-Wandler) bilden die Schnittstelle zwischen analogen und digitalen Schaltkreisen und werden in einer Vielzahl von Applikationen, wie z.B. in Mikro-Controllern und Steuergeräten eingesetzt.

Bekannte A/D-Wandler, wie z.B. Flash- oder Pipeline-Wandler, haben eine vorgegebene Auflösung, wie z.B. 8, 10 oder 16 Bit, mit der ein analoger Wert in einen binären Wert gewandelt wird.

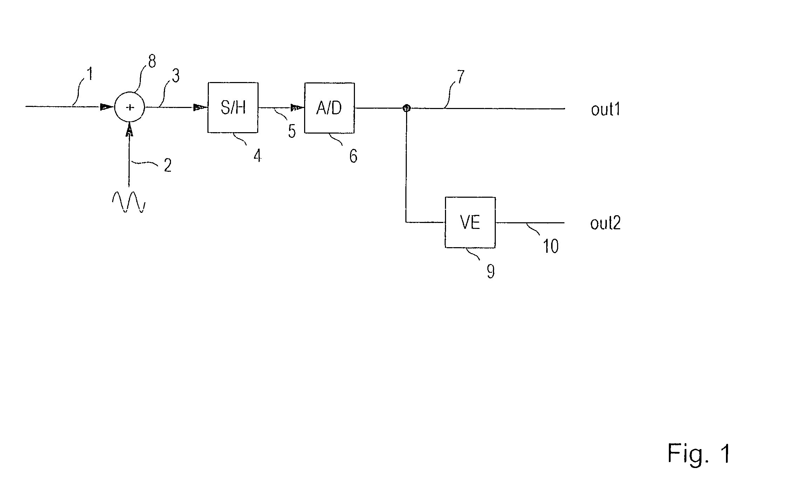

Ein typischer, aus dem Stand der Technik bekannter A/D-Wandler ist in Fig. 1 mit den Bezugszeichen 4 und 5 dargestellt. Fig. 1 zeigt eine A/D-Wandleranordnung, mit der ein analoges Eingangssignal 1 (z.B. ein analoger Meßwert) in eine digitales Ausgangssignal 7 (z.B. ein digitales 10-bit-Wort) gewandelt wird. Dabei wird der analoge Eingangswert 1 zunächst von einem S/H-Glied 4 abgetastet, und die Abtastwerte 5 jeweils mittels eines A/D-Wandlers 6 in ein digitales Ausgangssignal 7 gewandelt.

Die Auflösung wird dabei durch das kleinste Bit LSB (Least Significant Bit) des A/D-Wandlers 6 bestimmt. Eine höhere Auflösung kann nur durch Verwendung eines A/D-Wandlers 6 mit einer höheren Auflösung (z.B. 16 Bit anstelle von 10 Bit) erreicht werden. Dazu ist jedoch ein wesentlich aufwändigerer A/D-Wandler 6 mit wesentlich mehr Komparatoren erforderlich, der entsprechend teurer wäre.

Es ist daher die Aufgabe der vorliegenden Erfindung, die Auflösung eines vorgegebenen A/D-Wandlers in einfacher und kostengünstiger Weise zu erhöhen.

Gelöst wird diese Aufgabe gemäß der Erfindung durch die im Patentanspruch 1 angegebenen Merkmale. Weitere Ausgestaltungen der Erfindung sind Gegenstand von Unteransprüchen.

Der wesentliche Gedanke der Erfindung besteht darin, ein zu wandelndes Analogsignal mit einem Hilfssignal zu überlagern, das überlagerte Gesamtsignal mittels eines S/H-Glieds abzutasten, die Abtastwerte mittels eines A/D-Wandlers in digitale Ausgangswerte zu wandeln und auf der Grundlage mehrerer Ausgangswerte einen binären Ausgangswert mit höherer Auflösung zu bestimmen. Durch die Überlagerung des analogen Eingangssignals mit dem Hilfssignal entstehen digitale Ausgangswerte, die sich um wenigstens ein Bit unterscheiden können. Aus der Anzahl von Ausgangswerten mit höherem Bitwert oder der Anzahl von Ausgangswerten mit niedrigerem Bitwert lässt sich beispielsweise ermitteln, in welchem Bereich der Auflösung eines Bits sich das analoge Eingangssignal tatsächlich befindet. Die Auflösung kann somit erhöht werden.

Gemäß einer ersten Ausführungsform der Erfindung wird das überlagerte Signal mehrmals abgetastet und die Abtastwerte jeweils in digitale Ausgangswerte gewandelt, aus denen ein Mittelwert gebildet wird. Bei einer Auswertung von n-Abtastwerten (z.B. n=8) kann eine zusätzliche Auflösung von $\sqrt{n+1}$ Bit (3 Bit) erreicht werden. Wegen der erforderlichen Abtastung des überlagerten Signals steht der hoch aufgelöste Ausgangswert jedoch erst nach n-Abtastschritten (z.B. n=8) zur Verfügung. Die digitalen Ausgangswerte mit der durch den A/D-Wandler vorgegebenen Auflösung stehen dagegen nach wie vor in Echtzeit zur Verfügung.

Ein hoch aufgelöster Ausgangswert 10 lässt sich auch aus der Anzahl der Ausgangswerte 7 mit höherem Bitwert oder der Anzahl der Ausgangswerte 7 mit niedrigerem Bitwert im Verhältnis zur Gesamtzahl der eingelesenen Ausgangswerte 7 ermitteln.

Das überlagerte Signal wird vorzugsweise mit einer Frequenz abgetastet, die es ermöglicht, Abtastwerte auf der positiven und auf der negativen Amplitude des überlagerten Signals aufzunehmen. Die Abtastfrequenz wird vorzugsweise derart gewählt, dass sowohl bezüglich der Abtastwerte auf der positiven Amplitude als auch bezüglich der Abtastwerte auf der negativen Amplitude des überlagerten Signals eine Schwebung entsteht.

Das Hilfssignal hat vorzugsweise eine Spitze-Spitze-Amplitude, die größer gleich der Auflösung des kleinsten Bits der digitalen Ausgangswerte ist. Ist die Spitze-Spitze-Amplitude des Hilfssignals wenigstens so groß wie die Auflösung des LSB (Least Significant Bit) kann das Rauschen (z.B. thermisches Rauschen) des A/D-Wandlers reduziert werden. Ferner kann ein Teil des Linearitätsfehlers des A/D-Wandlers kompensiert werden.

Das zum Eingangssignal hinzu addierte Hilfssignal ist vorzugsweise ein periodisches Signal, wie z. B. ein Sinus- oder ein Rechtecksignal.

Die Abtastfrequenz des S/H-Glieds beträgt vorzugsweise etwa das zweifache der Frequenz des Hilfssignals.

Eine A/D-Wandleranordnung zur Verbesserung der Auflösung eines A/D-Wandlers umfaßt entsprechend eine Einrichtung zur Überlagerung eines Analogsignals mit einem Hilfssignal, wobei ein überlagertes Signal erzeugt wird, ein S/H-Glied zum Abtasten des überlagerten Signals und einen A/D-Wandler, der die Abtastwerte in digitale Ausgangswerte umsetzt. Ferner umfaßt die A/D-Wandleranordnung eine Verarbeitungseinheit, die aus den digitalen Ausgangswerten, z. B. durch Bildung eines Mittelwertes, einen digitalen Ausgangswert mit höherer Auflösung ermittelt.

Die Einrichtung zur Überlagerung des Hilfssignals kann z.B. einen Kondensator oder eine Stromquelle umfassen.

Die Erfindung wird nachstehend anhand der beigefügten Zeichnungen beispielhaft näher erläutert. Es zeigen:

Fig. 1 eine Ausführungsform einer A/D-Wandleranordnung zur Verbesserung der Auflösung eines A/D-Wandlers;

Fig. 2 eine Darstellung eines überlagerten Signals mit Abtastwerten;

Fig. 3a eine Darstellung der Bitauflösung bei herkömmlicher Messung;

Fig. 3b,3c eine Darstellung der Auflösung bei Anwendung eines Überlagerungsverfahrens gemäß der Erfindung;

Fig. 4a eine erste Ausführungsform einer Anordnung zur Einspeisung eines Hilfssignals;

Fig. 4b eine zweite Ausführungsform einer Anordnung zur Einspeisung eines Hilfssignals; und

Fig. 5 ein Flußdiagramm zur Darstellung eines Überlagerungsverfahrens zur Verbesserung der Auflösung eines A/D-Wandlers gemäß der Erfindung.

Fig. 1 zeigt ein Ausführungsbeispiel einer A/D-Wandleranordnung mit einem A/D-Wandler 6 und einem S/H-Glied 4 zum Abtasten und Halten eines analogen Eingangssignals. Dieser Aufbau entspricht einem herkömmlichen, aus dem Stand der Technik bekannten A/D-Wandler. Bei diesem wird die Auflösung durch das kleinste Bit LSB (Least Significant Bit) bestimmt. Eine höhere Auflösung kann nur durch Verwendung eines A/D-Wandlers 6 mit einer höheren Auflösung erreicht werden.

Im Unterschied zum Stand der Technik wird das analoge Eingangssignal 1 noch vor der Abtastung durch das S/H-Glied 4 mit einem Hilfssignal 2 überlagert. Das Hilfssignal 2 ist vorzugsweise ein periodisches Signal, im vorliegenden Beispiel ein Sinussignal. Zu Zwecken der Überlagerung ist eine Überlagerungs- bzw. Addiereinrichtung 8 vorgesehen.

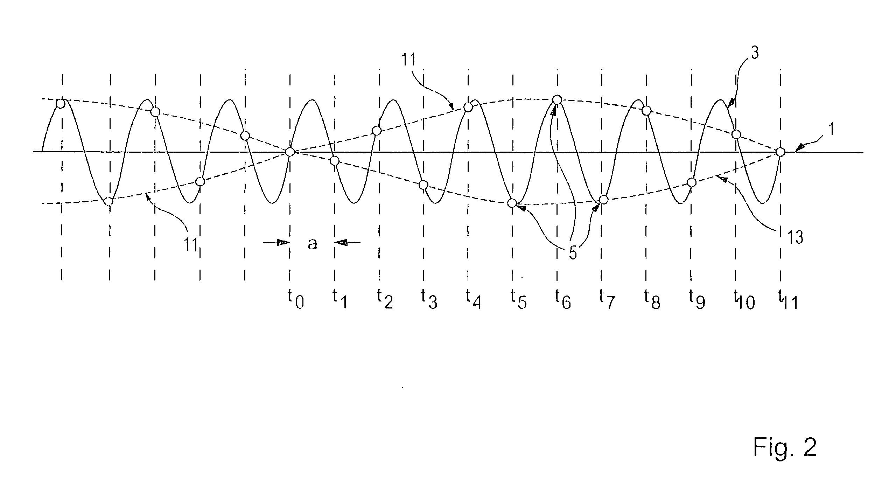

Das Ergebnis dieser Signalüberlagerung und der Abtastung ist in Fig. 2 dargestellt. Fig. 2 zeigt ein Überlagerungssignal 3, das durch Addition eines analogen Eingangssignals 1 mit einem sinusförmigen Hilfssignal 2 erzeugt wurde. Fig. 2 zeigt ferner mehrere Abtastwerte 5, die jeweils auf der positiven Amplitude und auf der negativen Amplitude des überlagerten Signals 3 liegen. Wird die Abtastfrequenz des S/H-Glieds 4 derart gewählt, dass sie etwa die doppelte Frequenz aufweist wie die Frequenz des Hilfssignals 2, so entsteht sowohl für die auf der positiven Amplitude des überlagerten Signals 3 liegenden Abtastwerte 5 als auch für die auf der negativen Amplitude des überlagerten Signals 3 liegenden Abtastwerte 5 eine Schwebung 11. Anders ausgedrückt entsteht eine Schwebung 11, wenn die Dauer der Abtastintervalle a in einer ähnlichen Größenordnung liegt wie die halbe Periodendauer des überlagerten Signals 3.

Die digital gewandelten Abtastwerte 5 (=Ausgangswerte 7) werden schließlich von einer Verarbeitungseinheit 9 ausgewertet und z.B. gemittelt.

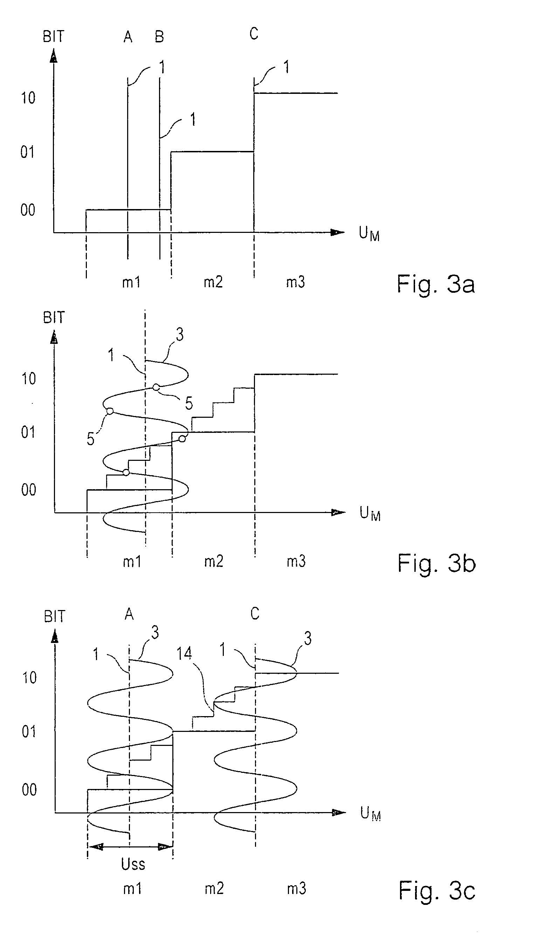

Die Fig. 3a-3c zeigen den durch die Signalüberlagerung erzielten Effekt, nämlich die Verbesserung der Auflösung des A/D-Wandlers, in graphischer Darstellung. Fig. 3a zeigt die letzten beiden Bits eines digitalen Ausgangswertes 7 über einem Messsignal $U_M$.

Der A/D-Wandler 6 hat im dargestellten Beispiel eine Auflösung von 10 mV. Daraus gibt sich im Bereich zwischen 0-10 mV ein binärer Wert 00 für die letzten beiden Bits des digitalen Ausgangswertes 7, in einem Wertebereich von 10,01 mV - 20 mV eine Kombination 01 und zwischen 20,01 mV - 30 mV eine Kombination 10 der letzten beiden Bits. Beträgt der Wert des analogen Meßsignals 1 beispielsweise 5 mV (Bezugszeichen A) so ergibt sich eine Kombination 00 der beiden letzten Bits des zugehörigen digitalen Ausgangswertes. Bei 9,9 mV (B) ergibt sich ebenfalls eine Kombination 00 der letzten beiden Bits. Bei 20mV (C) ergibt sich eine Kombination 01.

Fig. 3b zeigt nun die gleiche Abbildung, jedoch mit einem überlagerten Signal 3. Wie zu erkennen ist, enthält das überlagerte Signal 3 Abtastwerte 5, die einer Bitkombination 00, und Abtastwerte 5, die einer Bitkombination 01 entsprechen. Nach der digitalen Umwandlung der Abastwerte durch den A/D-Wandler 6 gibt es somit Ausgangswerte 7 mit einem höheren binären Wert und solche mit einem niedrigeren binären Wert. Aus der Anzahl von Ausgangswerten 7 mit höherem Bitwert und der Anzahl von Ausgangswerten mit niedrigerem Bitwert lässt sich ermitteln, in welchem Bereich der Auflösung eines Bits sich das analoge Eingangssignal tatsächlich befinden.

Die Verarbeitungseinheit 9 liest hierzu die in n-Abtastschritten erzeugten und digital gewandelten Ausgangswerte 7 ein. Der Lesezeitraum ist vorzugsweise wenigstens eine halbe Periode der Periodendauer der Schwebung 11.

Eine erste Möglichkeit zur Ermittlung eines höher aufgelösten Ausgangswertes 10 besteht darin, mehrere der digitalen Ausgangswerte 7 einzulesen und eine Mittelung der digitalen Werte 7 durchzuführen. Eine andere Möglichkeit besteht darin, den hoch aufgelösten Ausgangswert 10 aus dem Verhältnis der Anzahl der Ausgangswerte 7 mit höherem Bitwert oder der Anzahl der Ausgangswerte 7 mit niedrigerem Bitwert zur Gesamtzahl der eingelesenen Ausgangswerte 7 zu ermitteln.

Im Fall von Fig. 3b gibt es drei Ausgangswerte 7 mit einem digitalen Wert 00 und nur einen mit einem Bitwert 01. Das Verhältnis der Ausgangswerte 7 mit einem digitalen Wert 00 zur Gesamtzahl der eingelesenen Werte ist 3/4. Daraus ergibt sich, dass das analoge Eingangssignal etwa bei 7,5mV liegen muss. Bei einer Auswertung von n-Abtastwerten (z.B. n=8) kann eine zusätzliche Auflösung von $\sqrt{n}+1$ Bit (3 Bit) erreicht werden.

Im Fall A von Fig. 3c haben die letzten beiden Bits aller digitalen Ausgangswerte 7 einen binären Wert 00. Daraus kann gefolgert werden, dass das gesuchte Eingangssignal 1 genau in der Mitte des Auflösungsbereichs, also bei etwa 5mV, liegt. Dies entspricht in der höheren Auflösung einem Wert 0010.

Die zusätzlichen Bits sind mit dem Bezugszeichen 14 gekennzeichnet. Im vorliegenden Beispiel wird die Auflösung um 2 Bit erweitert. Der hoch aufgelöste Ausgangswert 10 kann nun z.B. die Werte 0000, 0001, 0010 und 0011 annehmen, wobei die letzten beiden Stellen die zusätzlichen Bits darstellen.

Im Fall C ist die Anzahl der digitalen Ausgangswerte 7 mit einem höheren Wert gleich der Anzahl der digitalen Ausgangswerte 7 mit einem niedrigeren Wert. Daraus kann gefolgert Werden, dass der gesuchte Meßwert 1 genau an der Grenze zwischen zwei Auflösungsbereichen m2,m3 liegt. Der hoch aufgelöste Ausgangswert 10 erhält somit die binäre Darstellung 1000.

Die Spitze-Spitze-Amplitude Uss ist vorzugsweise größer als die Auflösung eines Auflösungsbereichs ml-m3. Dadurch kann schon bei Berücksichtigung einer relativ kleinen Anzahl von Ausgangswerten 7 der Wert des analogen Eingangssignals 1 relativ genau bestimmt werden.

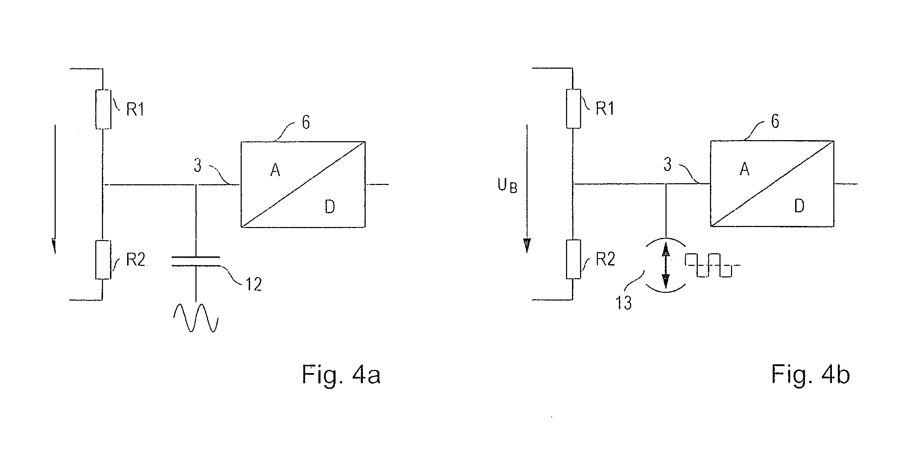

Fig. 4a zeigt eine erste Ausführungsform einer Schaltungsanordnung zur Einspeisung eines Hilfssignals 2. Die Schaltungsanordnung umfaßt einen Spannungsteiler R1,R2, der dazu dient, die analoge Meßgröße, wie z.B. eine Batteriespannung $U_B$ auf einen vom A/D-Wandler 6 verarbeitbaren Wert zu teilen. Das Hilfssignal 2 wird hier über einen Kondensator 12 am Eingang des A/D-Wandlers 6 eingespeist und überlagert das dort anliegende Analogsignal.

Fig. 4b zeigt eine andere Ausführungsform einer Schaltung zur Einspeisung eines Hilfssignals 2, die im wesentlichen identisch aufgebaut ist wie in Fig. 4a. Die Einspeisung des Hilfssignals 2 erfolgt jedoch in diesem Fall mittels einer Stromquelle 13, die periodisch umgepolt wird. Dadurch entsteht ein Rechtecksignal, das dem analogen Eingangssignal überlagert wird.

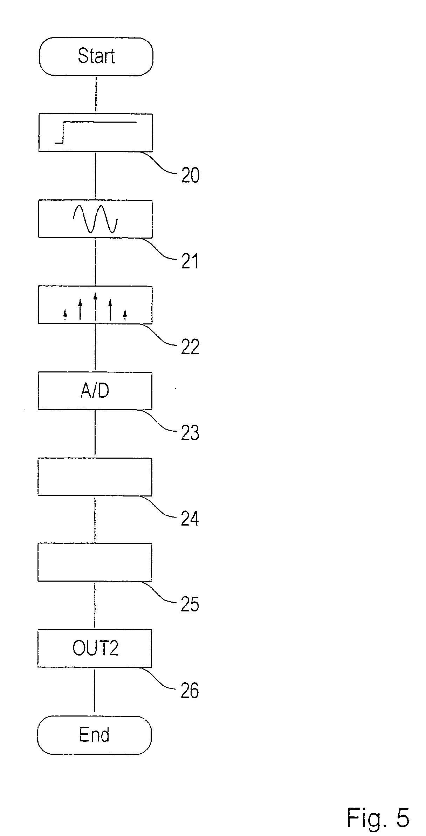

Fig. 5 zeigt die wesentlichen Schritte eines Verfahrens zur Verbesserung der Auflösung eines A/D-Wandlers. Dabei wird in Schritt 20 zunächst ein Analogsignal 1 aufgenommen und in Schritt 21 das Hilfssignal 2 überlagert. Das überlagerte Signal 3 wird in Schritt 22 abgetastet und die Abtastwerte 5 mittels des A/D-Wandlers 6 in binäre Ausgangswerte 7 gewandelt (Schritt 23). Diese Ausgangswerte 7 besitzen noch die durch den A/D-Wandler 6 bestimmte Auflösung (z.B. 10 Bit).

In Schritt 24 wird von der Verarbeitungseinheit 9 eine vorgegebene Anzahl von digitalen Ausgangswerten 7 eingelesen und in Schritt 25 ein digitaler Ausgangswert mit höherer Auflösung ermittelt. Dies kann z. B. durch Mittelwertbildung der eingelesenen digitalen Ausgangswerte 7 oder durch Bestimmung der Anzahl von Ausgangswerten 7 mit höherem oder niedrigerem Bitwert im Verhältnis zur Gesamtzahl der eingelesenen Ausgangswerte 7 erfolgen.

Der so ermittelte, hoch aufgelöste Ausgangswert 10 wird schließlich in Schritt 26 am Ausgang out2 ausgegeben. Die Ausgangswerte 7 werden vorzugsweise ebenfalls ausgegeben (Ausgang out1).

Bezugszeichenliste

| | |
|---|---|
| 1 | Analoges Eingangssignal |
| 2 | Hilfssignal |
| 3 | Überlagertes Signal |
| 4 | S/H-Glied |
| 5 | Abtastwerte |
| 6 | A/D-Wandler |
| 7 | Digitale Ausgangswerte |
| 8 | Einrichtung zur Signalüberlagerung |
| 9 | Verarbeitungseinheit |
| 10 | Ausgangswert mit höherer Auflösung |
| 11 | Schwebung |
| 12 | Kondensator |
| 13 | Stromquelle |
| R1,R2 | Widerstände |
| $U_B$ | Batteriespannung |
| m1-m3 | Auflösungsbereiche |
| Uss | Spitze-Spitze-Amplitude |

**Patentansprüche**

1. Verfahren zur Verbesserung der Auflösung eines A/D-Wandlers, **gekennzeichnet durch** folgende Schritte:

   - Aufnehmen eines Analogsignals (1),
   - Überlagern des Analogsignals (1) mit einem Hilfssignal (2), wobei ein überlagertes Signal (3) erzeugt wird,
   - Abtasten (22) des überlagerten Signals (3) mittels eines S/H-Glieds (4), wobei Abtastwerte (5) erzeugt werden,
   - A/D-wandeln (23) der Abtastwerte (5), wodurch eine Anzahl von digitalen Ausgangswerten (7) erzeugt wird,
   - Ermitteln (24,25) eines hoch aufgelösten digitalen Ausgangswertes (10) auf der Grundlage mehrerer Ausgangswerte (7).

2. Verfahren nach Anspruch 1, **dadurch gekennzeichnet, dass** der hoch aufgelöste digitale Ausgangswert (10) durch Mittelwertbildung mehrerer Ausgangswerte (7) ermittelt wird.

**3.** Verfahren nach Anspruch 1, **dadurch gekennzeichnet, dass** der hoch aufgelöste digitale Ausgangswert (10) aus dem Verhältnis der Anzahl der Ausgangswerte (7) mit höherem Bitwert oder der Anzahl der Ausgangswerte (7) mit niedrigerem Bitwert zur Gesamtzahl der eingelesenen Ausgangswerte (7) ermittelt wird.

**4.** Verfahren nach einem der vorhergehenden Ansprüche, **dadurch gekennzeichnet, dass** das Hilfssignal (2) ein periodisches Signal ist.

**5.** Verfahren nach einem der vorhergehenden Ansprüche, **dadurch gekennzeichnet, dass** das Hilfssignal (2) eine Spitze-Spitze-Amplitude aufweist, die größer oder gleich der Auflösung des kleinsten Bits der binären Ausgangswerte (7) ist.

**6.** Verfahren nach einem der vorhergehenden Ansprüche, **dadurch gekennzeichnet, dass** das Hilfssignal (2) ein Sinus- oder Rechtecksignal ist.

**7.** Verfahren nach einem der vorhergehenden Ansprüche, **dadurch gekennzeichnet, dass** eine Abtastfrequenz, mit der das überlagerte Signal (3) vom S/H-Glied (4) abgetastet wird, derart bemessen ist, dass eine Schwebung (11) entsteht.

**8.** A/D-Wandleranordnung mit einem S/H-Glied (4) zum Abtasten eines Analogsignals (1,3) und einem A/D-Wandler (6), **gekennzeichnet durch**

- eine Einrichtung (8,12,13) zur Überlagerung des Analogsignals (1) mit einem Hilfssignal (2), wodurch ein überlagertes Signal (3) entsteht
- das S/H-Glied (4) zum Abtasten des überlagerten Signals (3), wobei Abtastwerte (5) entstehen,
- den A/D-Wandler (6), der die Abtastwerte (5) in binäre Ausgangswerte (7) wandelt, und
- eine Verarbeitungseinheit (9), die auf der Grundlage mehrerer der Ausgangswerte (7) einen hoch aufgelösten Ausgangswert (10) ermittelt.

**9.** A/D-Wandleranordnung nach Anspruch 8, **dadurch gekennzeichnet, dass** die Verarbeitungseinheit (9) den hoch aufgelösten digitalen Ausgangswert (10) durch Mittelwertbildung mehrerer Ausgangswerte (7) ermittelt.

**10.** A/D-Wandleranordnung nach Anspruch 8, **dadurch gekennzeichnet, dass** die Verarbeitungseinheit (9) den hoch aufgelösten digitalen Ausgangswert (10) aus dem Verhältnis der Anzahl der Ausgangswerte (7) mit höherem Bitwert oder der Anzahl der Ausgangswerte (7) mit niedrigerem Bitwert zur Gesamtzahl der eingelesenen Ausgangswerte (7) ermittelt.

mittelt.

**11.** A/D-Wandleranordnung nach einem der Ansprüche 8 bis 10, **dadurch gekennzeichnet, dass** die Einrichtung (8) zur Überlagerung des Analogsignals (1) einen Kondensator (12) oder eine Stromquelle (13) umfaßt.

Fig. 1

Fig. 2

Fig. 3a

Fig. 3b

Fig. 3c

Fig. 4a

Fig. 4b

Fig. 5